(19) Europäisches Patentamt
European Patent Office
Office européen des brevets

(11) **EP 1 779 521 B1**

(12) **EUROPÄISCHE PATENTSCHRIFT**

(45) Veröffentlichungstag und Bekanntmachung des Hinweises auf die Patenterteilung:
**28.03.2018 Patentblatt 2018/13**

(21) Anmeldenummer: **05749321.5**

(22) Anmeldetag: **31.05.2005**

(51) Int Cl.:
*H03M 3/02* *(2006.01)*    *G01P 15/125* *(2006.01)*

(86) Internationale Anmeldenummer:
**PCT/EP2005/052476**

(87) Internationale Veröffentlichungsnummer:
**WO 2006/008207 (26.01.2006 Gazette 2006/04)**

(54) **SIGMA-DELTA-MODULATOR**

SIGMA-DELTA MODULATOR

MODULATEUR SIGMA-DELTA

(84) Benannte Vertragsstaaten:
**DE FR IT**

(30) Priorität: **17.07.2004 DE 102004034674**

(43) Veröffentlichungstag der Anmeldung:
**02.05.2007 Patentblatt 2007/18**

(73) Patentinhaber: **ROBERT BOSCH GMBH**
**70442 Stuttgart (DE)**

(72) Erfinder:
• **HELLWIG, Wolfgang**
**72810 Gomaringen (DE)**
• **WREDE, Martin**
**72770 Reutlingen (DE)**
• **WUCHER, Gerhard**
**72762 Reutlingen (DE)**
• **DROSTE, Dirk**
**72076 Tuebingen (DE)**

• **WALKER, Thomas**
**72127 Kusterdingen (DE)**

(56) Entgegenhaltungen:
**US-A- 5 454 266**

• **SMITH T ET AL: "A 15B ELECTROMECHANICAL SIGMA-DELTA CONVERTER FOR ACCELERATION MEASUREMENTS" IEEE INTERNATIONAL SOLID STATE CIRCUITS CONFERENCE, IEEE INC. NEW YORK, US, Bd. 37, 1. Februar 1994 (1994-02-01), Seiten 160-161,330, XP000507100 ISSN: 0193-6530**
• **KULAH H ET AL: "A CMOS switched-capacitor interface circuit for an integrated accelerometer" PROCEEDINGS OF THE 43RD. IEEE MIDWEST SYMPOSIUM ON CIRCUITS AND SYSTEMS. MWSCAS 2000. LANSING, MI, AUG. 8 - 11, 2000, MIDWEST SYMPOSIUM ON CIRCUITS AND SYSTEMS, NEW YORK, NY : IEEE, US, Bd. VOL. 1 OF 3, 8. August 2000 (2000-08-08), Seiten 244-247, XP010558120 ISBN: 0-7803-6476-7**

**Beschreibung**

Stand der Technik

Die Erfindung geht von einer Schaltung zur Wandlung der kapazitiven Signaländerung eines Differential-Kondensators in digitale Signale aus, wobei die Schaltung einen Sigma-Delta-Modulator beinhaltet.

Beschleunigungs-Sensoren werden unter anderem mit mikromechanischen Differentialkondensatoren dargestellt. Dabei wird eine kapazitive Signaländerung durch eine Auslenkung x der gemeinsamen Elektrode (im weiteren Verlauf als seismische Masse bezeichnet) verursacht. Die Auslenkung x kann durch von außen einwirkende Beschleunigungen oder durch innerhalb des Systems aufgebrachte elektrostatische Feldkräfte entstehen. Die kapazitive Änderung beträgt fair die Teilkapazitäten C1 und C2:

$$C1 = \varepsilon * A / (d+x), \quad C2 = \varepsilon * A / (d-x).$$

Dabei ist $\varepsilon$ die Dielektrizitätskonstante, A die von den Elektroden gebildete Kondensatorfläche und d der Plattenabstand der Elektroden. Typische Ausleseschaltkreise zum Erfassen dieser kapazitiven Signaländerungen wenden die Switched-Capacitor-Schaltungstechnik an, um eine von der kapazitiven Signaländerung abhängige, durch Referenzspannungen erzeugt Ladung durch Integration in eine Spannung und anschließend in ein digitales, Puls-Code-moduliertes Signal (PCM-Signal) zu wandeln. Dabei gibt es im Wesentlichen zwei Architekturen, um das analoge kapazitive Signal in eine Spannung zu wandeln und anschließend zu digitalisieren. Beide Ansätze erzeugen dabei eine Umwandlung des kapazitiven Signals in eine Spannung durch einen Ladungsverstärker.
Im ersten Ansatz wird diese Spannung digitalisiert. Hierbei gibt es die Möglichkeit, nach Filterung der Spannung eine Nyquist-Wandlung oder ohne Filterung eine Modulations-Wandlung der Spannung vorzunehmen. Im Falle der Modulations-Wandlung kann der Differential-Kondensator Bestandteil der Signalzuführungsstruktur eines klassischen Sigma-Delta-Wandlers sein.
Im zweiten Ansatz wird das Signal durch einen modulierten mechanischen geschlossenen Regelkreis mit Hilfe der Sigma-Delta-Modulation digitalisiert. Die Regelgröße ist dabei die resultierende Krafteinwirkung auf die seismische Masse des Differential-Kondensators.
Aus dem Dokument SMITH T ET AL: "A 15B ELECTROMECHANICAL SIGMA-DELTA CONVERTER FOR ACCELERATION MEASUREMENTS" (IEEE INTERNATIONAL SOLID STATE CIRCUITS CONFERENCE, IEEE INC. NEW YORK) geht eine Schaltung mit einem Differential-Kondensator, einem Sigma-Delta-Modulator und Mitteln, durch welche Referenzspannungen an Elektroden des Differential-Kondensators anlegbar sind, hervor. Der Differential-Kondensator ist Bestandteil einer Signalzuführungsstruktur als auch einer Referenzrückkopplungsstruktur des Sigma-Delta-Modulators. Die Patentschrift US 5,454,266 A und das Dokument KULAH H ET AL: "A CMOS SWITCHED-CAPACITOR INTERFACE CIRCUIT FOR AN INTEGRATED ACCELEROMETER" (PROCEEDINGS OF THE 43RD. IEEE MIDWEST SYMPOSIUM ON CIRCUITS AND SYSTEMS) betreffen ähnliche Schaltungen.

Vorteile der Erfindung

Die Erfindung geht von einer Schaltung zur Wandlung der kapazitiven Signaländerung eines Differential-Kondensators in digitale Signale aus, wobei die Schaltung einen Sigma-Delta-Modulator beinhaltet. Der Kern der Erfindung besteht darin, dass der Differentialkondensator Bestandteil der Signalzuführungsstruktur und der Referenzrückkopplungsstruktur des Sigma-Delta-Modulators ist.

Vorteilhaft ist hierbei, dass eine Kapazitätsänderung direkt von einem analogen Wert in ein digitales Signal, insbesondere einen Bitstrom gewandelt werden kann. Der Vorteil der Erfindung liegt weiterhin in der Verbesserung der Rausch-Eigenschaften gegenüber dem im Stand der Technik vorgestellten zweiten Ansatz und in der Verbesserung der Linearität des Ausgangssignal gegenüber dem im Stand der Technik vorgestellten ersten Ansatz. Eigenschaften von Rauschen und Linearität werden gegenüber beiden Ansätzen verbessert. Durch die Einbindung des Differential-Kondensators in die Signalzuführungs- und die Referenzrückkopplungsstruktur des Sigma-Delta-Wandlers wird das Ausgangssignal des Wandlers in Form eines Binärstromes in erster Näherung nur abhängig von der Auslenkung der seismischen Masse des Differential-Kondensators und ist daher ein proportionales Maß zu der auf die seismische Masse einwirkende Beschleunigung:

$$PCM = k * (C1 - C2) / (C1 + C2) \sim x/d.$$

Eine vorteilhafte Ausgestaltung der Erfindung beinhaltet, dass die Schaltung neben dem Sigma-Delta-Modulator auch ein Dezimierfilter aufweist und somit einen Sigma-Delta-Wandler darstellt. Mittels eines Dezimierfilters kann die Abtastrate am Ausgang gesenkt werden und das digitale Signal mittels eines Wortes mit bestimmter Bitanzahl (Wortbreite) dargestellt werden.

Erfindungsgemäß sind Mittel vorgesehen, mittels derer verschiedene Referenzspannungen an die Elektroden (C1E, CME, C2E) des Differentialkondensators anlegbar sind, und dass die Referenzspannungen in einem bestimmten zeitlichen Muster mit bestimmter Amplitude wählbar sind. Durch verschieden gewählte Referenzspannungen können verschiedene Wertebereiche und Auflösungen des zu digitalisierenden Signals dargestellt werden. Außerdem werden hierdurch vorteilhafte Weiterbildungen der Erfindung möglich.

Eine erfindungsgemäße Weiterbildung der Erfindung sieht vor, dass durch eine geeignet gewählte Abfolge der Referenzspannungen an den Elektroden (C1E, CME, C2E) ein Polaritätswechsel des Eingangs-Signals realisiert ist. Vorteilhaft ist hierbei die Möglichkeit, einen möglichen Offset der Signalverarbeitungskette durch Modulation des Eingangssignals zu eliminieren:

$$PCM = \pm k*(C1-C2)/(C1+C2) \sim \pm x/d.$$

Erfindungsgemäß wird durch Synchrondemodulation der digitalen Signale am Ausgang des Wandlers der Offset der Signalverarbeitung der Schaltung eliminiert.

Eine weitere vorteilhafte Ausgestaltung der Erfindung beinhaltet, dass durch eine geeignete Wahl der Referenzspannungen an den Elektroden (C1E, CME, C2E) eine Potentialgleichheit der Elektroden im zeitlichen Mittel gegeben ist. Der Vorteil der zweiten vorteilhaften Weiterbildung der Erfindung liegt in der Möglichkeit, die zeitliche elektrische Aufladung der seismischen Masse und die daraus entstehenden Änderung des Ausgangs-Signals zu verhindern.

$$\int \Phi C1E(t)\, dt \sim \int \Phi C2E(t)\, dt \sim \int \Phi CME(t)\, dt$$

Vorteilhaft ist schließlich, dass eine Elektrode (CME) beweglich ist und dass die Struktur wenigstens eine, durch elektrostatische Feldkräfte verursachte, Auslenkung der beweglichen Elektrode (CME) als Eingangssignal einer Selbsttestfunktion erfasst. Bei geeigneter Wahl der Referenzspannungen und eines geeigneten Taktschemas zum Aufschalten dieser Referenzspannungen auf die Elektroden (C1E, CME, C2E) kann eine Stellkraft auf die Elektrode (CME) ausgeübt werden. Die in der Folge auftretende Auslenkung der Elektrode kann im Rahmen einer Selbsttestfunktion ausgewertet werden.

Zeichnung

Ausführungsbeispiele der Erfindung sind in der Zeichnung dargestellt und in der nachfolgenden Beschreibung näher erläutert.

Fig. 1 zeigt einen Sigma-Delta-Modulator nach Stand der Technik.

Fig. 2 zeigt einen weiteren Sigma-Delta-Modulator nach Stand der Technik.

Fig. 3 zeigt das Taktschema für einen Sigma-Delta-Modulator nach Stand der Technik gemäß Fig. 1 oder Fig. 2.

Fig. 4 zeigt einen erfindungsgemäßen Sigma-Delta-Modulator mit Differentialkondensator.

Fig. 5 zeigt eine Schaltung zur Rückkopplung verschiedener Referenzspannungen in einen erfindungsgemäßen Sigma-Delta-Modulator.

Fig. 6 zeigt eine Schaltung zur Vertauschung verschiedener Referenzspannungen in einem erfindungsgemäßen Sigma-Delta-Modulator.

Fig. 7 zeigt einen erfindungsgemäßen Beschleunigungssensor mit Sigma-Delta-Modulator mit Differentialkondensator.

Anhand der im folgenden beschriebenen Ausführungsformen soll die Erfindung detailliert dargestellt werden.

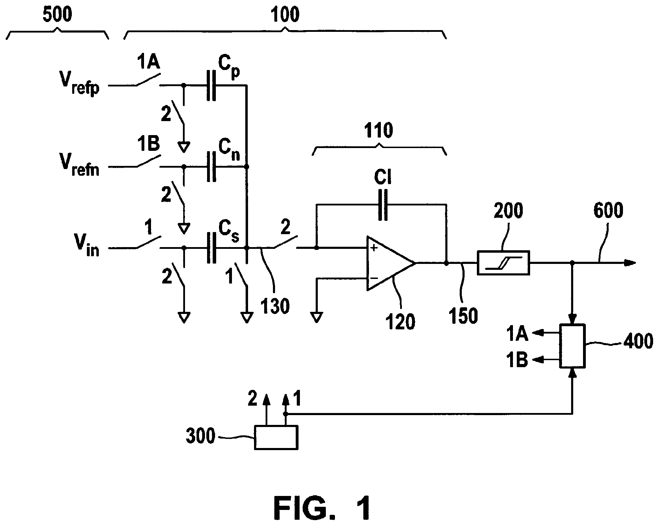

Fig. 1 zeigt einen Sigma-Delta-Modulator nach Stand der Technik. Die Schaltungsanordnung zeigt einen einpolig geerdeten Signalpfad. Der Sigma-Delta-Modulator weist einen Integrator mit geschalteten Kapazitäten 100 (engl. : SC-Integrator), einen Komparator 200, einen Taktgeber 300, eine Schalteinheit 400, drei Spannungseingänge 500 und einen Ausgang 600 auf. An den Spannungseingängen 500 liegen eine positive Referenzspannung Vrefp, eine negative Referenzspannung Vrefn und eine Eingangsspannung Vin an. Die Signalzuführung erfolgt also in Form der Eingangsspannung Vin. Der Integrator 100 weist am Spannungseingang mit der positiven Referenzspannung Vrefp ein erstes Schaltelement auf, welches mittels eines Signals 1A geschlossen werden kann. Mit dem Ausgang dieses ersten Schaltelements ist ein weiteres Schaltelement verbunden, welches mittels eines Signals 2 geschlossen werden kann und dabei eine Masseverbindung herstellt. Der Ausgang des ersten Schaltelements ist weiterhin mit einem Kondensator Cp verbunden. Der Integrator 100 weist am Spannungseingang mit der negativen Referenzspannung Vrefn ein zweites Schaltelement auf, welches mittels eines Signals 1B geschlossen werden kann. Mit dem Ausgang dieses zweiten Schaltelements ist ein weiteres Schaltelement verbunden, welches mittels eines Signals 2 geschlossen werden kann und dabei eine Masseverbindung herstellt. Der Ausgang des ersten Schaltelements ist weiterhin mit einem Kondensator Cn verbunden. Der Integrator 100 weist am Spannungseingang mit der Eingangsspannung Vin ein drittes Schaltelement auf, welches mittels eines Signals 1 geschlossen werden kann. Mit dem Ausgang dieses dritten Schaltelements ist ein weiteres Schaltelement verbunden, welches mittels eines Signals 2 geschlossen werden kann und dabei eine Masseverbindung herstellt. Der Ausgang des dritten Schaltelements ist weiterhin mit einem Kondensator Cs verbunden. Die Ausgänge der Kondensatoren Cp, Cn, und Cs sind miteinander verbunden und leiten ein Signal 130 zu einem Schaltelement weiter, welches mittels eines Signals 2 geschlossen werden kann. Das Signal 130 wird dadurch einem Integrationsglied 110 zugeführt. Das Integrationsglied 110 umfasst einen Kondensator CI und einen Verstärker 120. Das Integrationsglied 110 stellt an seinem Ausgang eine analoge Ausgangsspannung Vout in Form eines Signals 150 bereit, welches einem Schwellwertschalter, in diesem Beispiel einem Komparator 200 zugeführt wird. Der Komparator stellt an seinem Ausgang einen Binärstrom 600 bereit. Der Sigma-Delta-Modulator weist weiterhin einen Taktgeber 300 auf, der zwei Ausgänge besitzt. Der Taktgeber gibt an den beiden Ausgängen in einem nichtüberlappenden 2-Phasen-Takt die Taktsignale 1 und 2 aus. Schließlich weist der Sigma-Delta-Modulator eine Schalteinheit 400 auf, welche zwei Signaleingänge und 2 Signalausgänge besitzt. An den Signaleingängen liegen der Binärstrom 600 und das Taktsignal 2 an. An den Signalausgängen werden die Schaltsignale 1A und 1B bereitgestellt.

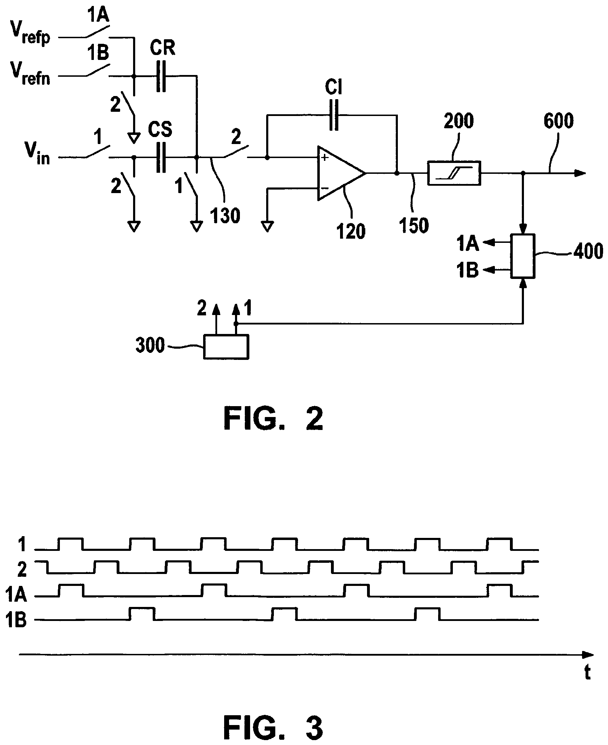

Fig. 2 zeigt einen weiteren Sigma-Delta-Modulator nach Stand der Technik. Der Sigma-Delta-Modulator nach Fig. 1 wurde leicht vereinfacht. Die Funktion der geschalteten Kondensatoren Cp und Cn wird hier durch einen gemeinsamen Kondensator CR dargestellt.

Fig. 3 zeigt das Taktschema für einen Sigma-Delta-Modulator nach Stand der Technik gemäß Fig. 1 oder Fig. 2. Dargestellt sind in Bezug auf eine gemeinsame Zeitachse t die logischen Zustände H (aktiv) und L (inaktiv). Die Taktsignale 1 und 2 stellen einen nichtüberlappenden 2-Phasen-Takt dar. Die Schaltsignale 1A und 1B werden in der Schalteinheit 400 nach folgenden logischen Regeln generiert:

1A = H, wenn Taktsignal 1 = HUND Binärstrom 600 = H,
1B = H, wenn Taktsignal 1 = H UND Binärstrom 600 = L.

Die Taktsignale 1A und 1B stellen eine Signalrückführung vom Binärstrom 600 am Ausgang des Sigma-Delta-Modulators über die Schalteinheit 400, über die Schaltelemente, welche die Spannungen Vrefp und Vrefn zuschalten und über die Kondensatoren C1 und C1 zum Eingangssignal 130 des Integrationsgliedes 110 dar. Die Kondensatoren C1 und C1 sind damit Bestandteil der Referenzrückkopplungsstruktur.

Wendet man das hier erläuterte Taktschema auf einen Sigma-Delta-Modulator nach Stand der Technik gemäß Fig. 1 an, so erhält man für die Ausgangsspannung (Vout) 150 im Taktschritt n+1 nach dem Taktschritt n:

Wenn gilt 1A = H, dann ist

$$Vout_{n+1} = Vout_n + (C1/C2) * Vin + (Cp/C2) * Vrefp \,,$$

Wenn gilt 1B = H, dann ist

$$Vout_{n+1} = Vout_n + (C1/C2) * Vin + (Cn/C2) * Vrefn \,.$$

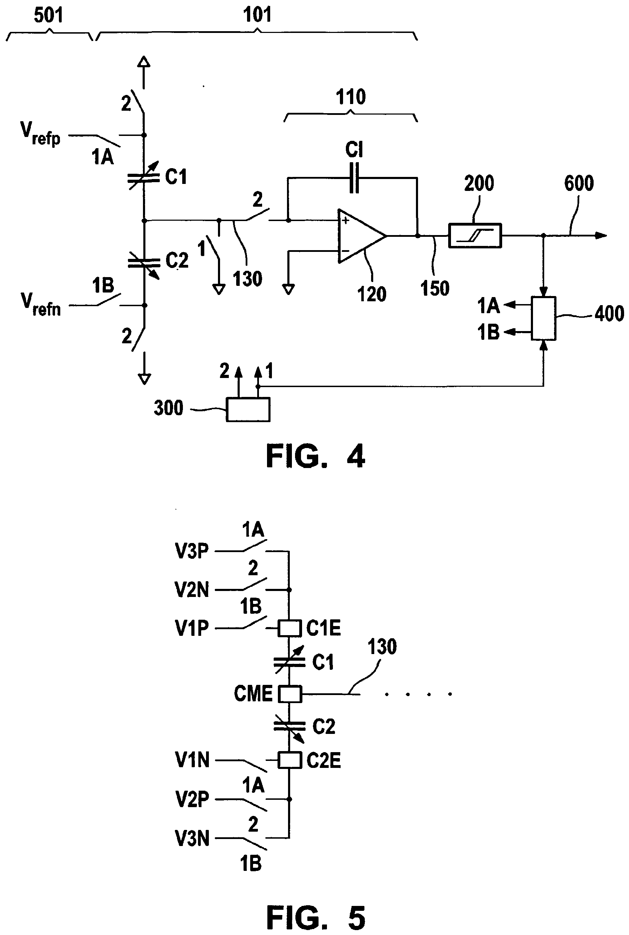

Fig. 4 zeigt einen erfindungsgemäßen Sigma-Delta-Modulator mit Differentialkondensator. Abweichend von dem in Fig. 1 dargestellten Sigma-Delta-Modulator weist dieser nur zwei Spannungseingänge 501 auf, an welche die Spannungen Vrefp und Vrefn angelegt sind. Eine Eingangsspannung Vin ist nicht vorgesehen. Weiterhin entfällt auch der Kondensator Cs. Die festen Kondensatoren Cp und Cn werden im erfindungsgemäßen Sigma-Delta-Modulator nunmehr durch die Kapazitäten C1 und C2 eines Differentialkondensators dargestellt. Ein solcher Differentialkondensator kann zum Beispiel ein kapazitiver Messwertaufnehmer eines mikromechanischen Beschleunigungssensors sein. Die Signalzuführung erfolgt also in Form der veränderlichen Kapazitäten C1 und C2 des Differentialkondensators. Das bedeutet, der Differentialkondensator ist Teil der Signalzuführungsstruktur. Weiterhin findet das in Fig. 3 dargestellte Taktschema Anwendung.

Der erfindungsgemäße Sigma-Delta-Modulator wandelt die Änderungen der analogen Differentialkapazitäten in einen Bitstrom 600 um.

Für die Differentialkapazitäten gilt:

$$C1 = C0 * ((e * A) / (\Delta d + d))$$

$$C2 = C0 * ((e * A) / (\Delta d - d))$$

In Näherung gilt:

$$C1 = C0 - \Delta C$$

$$C2 = C0 + \Delta C$$

Der Differential-Kondensator ersetzt vollständig die im Prinzip bekannte Signalzuführungs- und die Referenzrückführungsstruktur einer typischen Integratorstufe eines Sigma-Delta-Wandlers. Die Erfindung lässt sich dabei ebenso in einem einpolig geerdeten Signalpfad wie in einem zweipoligen Signalpfad ausführen. In allen hier gegebenen Erläuterungen wird ein einpolig geerdeter Signalpfad angenommen.

Durch die Regelung des Sigma-Delta-Wandlers und die gleichzeitige Anwendung des Differential-Kondensators in Signalzuführung und Referenzrückführung des Modulators wird am Ausgang des Komparators ein Binärstrom erzeugt. Das Gewicht des Binärstromes 600 des Modulators entspricht der Beziehung:

$$PCM = k * ( C1 - C2 ) / ( C1 + C2 ) = \Delta d / d \,.$$

Dieser Zusammenhang verdeutlicht die Linearität des Ausgangssignals zu der Auslenkung der seismischen Masse.

Fig. 5 zeigt eine Schaltung zur Rückkopplung verschiedener Referenzspannungen in einem erfindungsgemäßen Sigma-Delta-Modulator. Dargestellt ist die Schaltung eines erfindungsgemäßen Sigma-Delta-Modulators von den Spannungseingängen der Referenzspannungen bis zum Signal 130. Wie in Fig. 5 dargestellt, werden verschiedenen Referenzspannungen zu verschiedenen Zeiten an Elektroden C1E, CME und C2E eines Differentialkondensators, bestehend aus den Teilkapazitäten C1 und C2 angeschlossen. Die verschiedenen Referenzspannungen werden als VxP und VxN mit x ∈ (1,2,3) und VxP = -VxN mit x ∈ (1,2,3) bezeichnet, die verschiedenen Zeiten werden mittels der aus Fig. 2 bekannten Taktsignale 1A, 1B und 2 definiert. Die Zeiten stellen den bekannten 2-Phasen-Takt dar, wobei die Unterscheidung A und B der Phase 1 in Abhängigkeit vom Bitstrom 600 am Ausgang des Komparators 200 des Sigma-Delta-Wandlers in der Schalteinheit 400 getroffen wird.

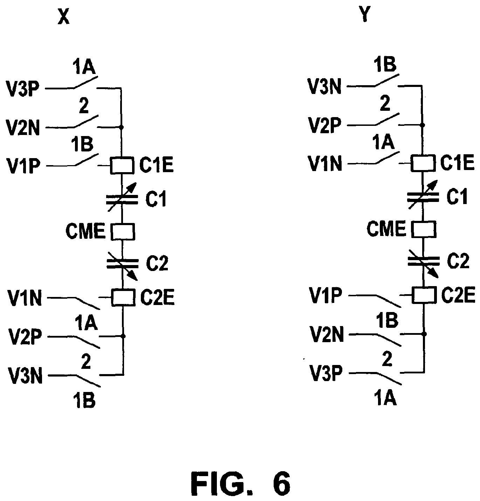

Fig. 6 zeigt eine Schaltung zur Vertauschung verschiedener Referenzspannungen in einen erfindungsgemäßen Sigma-Delta-Modulator. Eine erste vorteilhafte Weiterbildung der Erfindung ermöglicht eine Modulation, indem die Muster der Ansteuerung A und B um die Muster X und Y erweitert werden. Dabei werden gemäß Fig. 6 in Abhängigkeit des Wechsels von X und Y die Referenzspannungen VxN und VxP an den Elektroden C1E und C2E und gleichzeitig die Modulatorausgangs-abhängigen Zustände A und B gegeneinander vertauscht. Das Vertauschen der Referenzspannungen und der Zustände erfolgt beispielsweise mittels einer hier nicht näher dargestellten Schalteinheit. Der zeitliche Wechsel der Zustände X und Y entspricht dabei einer Frequenz, die eine andere ist, als die Modulationsfrequenz des Sigma-Delta-Modulators. Es entsteht am Ausgang des Komparators ein Binärstrom 600 mit der Beziehung:

$$PCM = \pm|_{XY}\ k * (\ C1 - C2\ )/(\ C1 + C2\ ) \sim \pm|_{XY}\ \Delta d/d\ .$$

Es entsteht in Abhängigkeit des Zustandes X oder Y ein Polaritätswechsel des PCM-Signals, so dass sich durch anschließende digitale Synchrondemodulation mit der Modulationsfrequenz der Zustände X und Y ein Signalversatz (engl.: Offset) der Signalverarbeitung innerhalb des Sigma-Delta-Wandlers eliminieren lässt.

Eine zweite vorteilhafte Weiterbildung der Erfindung gemäß Fig. 5 ermöglicht die zeitlich-integrale Potentialgleichheit der Elektroden C1E, CME und C2E. Hierzu wird die Referenzspannung V2P und V2N gewählt als:

$$V2P = 0.5 * (\ V1P + V3P\ )\ ,$$

$$V2N = 0.5 * (\ V1N + V3N\ )\ .$$

Durch die im Mittel ausgewogene Verteilung der Zustände A und B wird an jede Elektrode eine Abfolge von Referenzspannungen angeschlossen, die im zeitlichen Mittel eine hohe Potentialgleichheit von C1E, CME und C2E hervorruft.

$$\int\ \phi C1E(t)\ dt \sim \int\ \phi C2E(t)\ dt \sim \int\ \phi CME(t)\ dt$$

Eine dritte vorteilhafte Weiterbildung der Erfindung ermöglicht ein Auslenken der seismischen Masse eines aus der Ruhelage durch Anlegen von elektrischen Feldern innerhalb der Kondensatoren C1 und C2 mittels Test-Spannungen. Dies kann durch Überlagerung von additiven Test-Spannungen über den Spannungen VxP und VxN oder durch Anlegen von Test-Spannungen und Anlegen der Auslesespannungen VxP und VxN im Zeitmultiplex erfolgen.

Es sind daneben auch weitere vorteilhafte Weiterbildungen denkbar.

Eine Ausgestaltung der Erfindung ist ein ein Beschleunigungssensor mit Sigma-Delta-Modulator mit Differentialkondensator. Der Beschleunigungssensor besteht aus einem mikromechanischen Funktionsteil 700 und einer Auswerteeinheit 750. Der mikromechanische Funktionsteil 700 umfaßt eine seismische Masse 710, die mittels Federelemente 712 an einem einen festen Teil 714 aufgehängt ist. Die seismische Masse kann durch äußere Beschleunigungen entlang einer empfindlichen Achse x ausgelenkt werden. Daneben weist der mikromechanische Funktionsteil 700 wenigstens zwei feste Elektroden C1E und C2E auf. Die seismische Masse 710 weist eine Elektrode CME auf, die mit der seismischen Masse beweglich ist in Bezug auf die festen Elektroden. Die bewegliche Elektrode CME bildet mit der festen Elektrode C1E die veränderliche Kapazität C1 und mit der festen Elektrode C2E die veränderliche Kapazität C2. Die Elektroden C1E, CME und C2E bilden zusammen einen Differentialkondensator. Sie sind mittels elektrischer Leitungen 716, 130 mit der Auswerteeinheit 750 verbunden. Der Differentialkondensator und die Auswerteeinheit stellen zusammen einen erfindungsgemäßen Sigma-Delta-Modulator dar.

Es sind daneben auch weitere Ausführungsbeispiele denkbar. Insbesondere kann der erfindungsgemäße Sigma-Delta-Modulator auch bei Drehratensensoren eingesetzt werden.

**Patentansprüche**

**1.** Schaltung zur Wandlung der kapazitiven Signaländerung eines Differential-Kondensators in einen Bitstrom (600),

- wobei die Schaltung einen Sigma-Delta-Modulator beinhaltet,
- wobei Mittel vorgesehen sind, mittels derer Referenzspannungen an die Elektroden (C1E, CME, C2E) des Differentialkondensators anlegbar sind, wobei die Referenzspannungen in einem bestimmten zeitlichen Muster mit bestimmter Amplitude wählbar sind,

und wobei
der Differentialkondensator Bestandteil der Signalzuführungsstruktur ist, wobei das Eingangssignal durch die veränderlichen Kapazitäten des Differentialkondensators gebildet ist, und dass der Differentialkondensator Bestandteil der Referenzrückkopplungsstruktur des Sigma-Delta-Modulators ist, wobei zur Referenzrückkopplung die Mittel in Abhängigkeit von dem Bitstrom (600) betätigbar sind, **dadurch gekennzeichnet, dass** durch eine geeignet gewählte Abfolge der Referenzspannungen an den Elektroden (C1E, CME, C2E) ein Polaritätswechsel des Eingangssignals realisiert ist, wobei durch Synchrondemodulation des Bitstroms (600) am Ausgang des Sigma-Delta-Modulators der Offset der Signalverarbeitung der Schaltung eliminiert wird.

2. Schaltung nach Anspruch 1, **dadurch gekennzeichnet, dass** die Schaltung neben dem Sigma-Delta-Modulator auch ein Dezimierfilter aufweist und somit einen Sigma-Delta-Wandler darstellt.

3. Schaltung nach Anspruch 1, **dadurch gekennzeichnet, dass** durch eine geeignete Wahl der Referenzspannungen an den Elektroden (C1E, CME, C2E) eine Potentialgleichheit der Elektroden im zeitlichen Mittel gegeben ist.

4. Schaltung nach Anspruch 1, **dadurch gekennzeichnet, dass** eine Elektrode (CME) beweglich ist und dass die Struktur wenigstens eine, durch elektrostatische Feldkräfte verursachte, Auslenkung der beweglichen Elektrode (CME) als Eingangssignal einer Selbsttestfunktion erfasst.

5. Kapazitiver Sensor mit wenigstens einer beweglichen Elektrode (CME) und wenigstens zwei festen Elektroden (C1E, C2E), welche einen Differentialkondensator bilden, **dadurch gekennzeichnet, dass** der kapazitive Sensor eine Schaltung nach Anspruch 1 aufweist.

6. Kapazitiver Sensor nach Anspruch 5, **dadurch gekennzeichnet, dass** es sich um einen Beschleunigungssensor handelt.

**Claims**

1. Circuit for converting the capacitive signal change of a differential capacitor into a bit stream (600),

- wherein the circuit comprises a sigma-delta modulator,
- wherein means are provided by means of which reference voltages are able to be applied to the electrodes (C1E, CME, C2E) of the differential capacitor, wherein the reference voltages are selectable in a specific temporal pattern with a specific amplitude,

and wherein

the differential capacitor is part of the signal feeding structure, wherein the input signal is formed by the variable capacitances of the differential capacitor and wherein the differential capacitor is part of the reference feedback structure of the sigma-delta modulator, wherein, for the purpose of reference feedback, the means are actuatable depending on the bit stream (600), **characterized in that** a change in polarity of the input signal is realized by way of a suitably selected sequence of the reference voltages at the electrodes (C1E, CME, C2E), wherein the offset of the signal processing of the circuit is eliminated by synchronous demodulation of the bit stream (600) at the output of the sigma-delta modulator.

2. Circuit according to Claim 1, **characterized in that** the circuit also comprises a decimating filter besides the sigma-delta modulator and thus constitutes a sigma-delta converter.

3. Circuit according to Claim 1, **characterized in that** a suitable selection of the reference voltages at the electrodes (C1E, CME, C2E) results in a potential equality of the electrodes on average over time.

4. Circuit according to Claim 1, **characterized in that** one electrode (CME) is movable, and **in that** the structure detects at least one deflection of the movable electrodes (CME) that is caused by electrostatic field forces as an input signal of a self-test function.

5. Capacitive sensor comprising at least one movable electrode (CME) and at least two fixed electrodes (C1E, C2E), which form a differential capacitor, **characterized in that** the capacitive sensor comprises a circuit according to Claim 1.

6. Capacitive sensor according to Claim 5, **characterized in that** this is an acceleration sensor.

**Revendications**

**1.** Circuit pour convertir la variation de signal capacitive d'un condensateur différentiel en un train de bits (600),

- le circuit contenant un modulateur sigma-delta,
- des moyens étant présents, à l'aide desquels des tensions de référence peuvent être appliquées aux électrodes (C1E, CME, C2E) du condensateur différentiel, les tensions de référence pouvant être sélectionnées dans un modèle temporel donné avec une amplitude donnée,

et

le condensateur différentiel étant un élément constitutif de la structure d'arrivée de signal, le signal d'entrée étant formé par les capacités variables du condensateur différentiel, et le condensateur différentiel étant un élément constitutif de la structure de contre-réaction de référence du modulateur sigma-delta, les moyens pouvant être actionnés en fonction du train de bits (600) en vue de réaliser la contre-réaction de référence, **caractérisé en ce qu'**un changement de polarité du signal d'entrée est réalisé par une séquence sélectionnée de manière appropriée des tensions de référence au niveau des électrodes (C1E, CME, C2E), le décalage du traitement de signal du circuit étant éliminé par modulation synchrone du train de bits (600) à la sortie du modulateur sigma-delta.

**2.** Circuit selon la revendication 1, **caractérisé en ce que** le circuit possède également un filtre de décimation en plus du modulateur sigma-delta et représente ainsi un convertisseur modulateur sigma-delta.

**3.** Circuit selon la revendication 1, **caractérisé en ce qu'**une égalité des potentiels des électrodes en moyenne dans le temps est obtenue par une sélection appropriée des tensions de référence au niveau des électrodes (C1E, CME, C2E).

**4.** Circuit selon la revendication 1, **caractérisé en ce qu'**une électrode (CME) est mobile et **en ce que** la structure détecte en tant que signal d'entrée d'une fonction d'autotest au moins une déviation de l'électrode (CME) mobile, provoquée par des forces de champ électrostatiques.

**5.** Capteur capacitif comprenant au moins une électrode mobile (CME) et au moins deux électrodes fixes (C1E, C2E), lesquelles forme un condensateur différentiel, **caractérisé en ce que** le capteur capacitif possède un circuit selon la revendication 1.

**6.** Capteur capacitif selon la revendication 5, **caractérisé en ce qu'**il s'agit d'un capteur d'accélération.

**FIG. 1**

FIG. 2

FIG. 3

## FIG. 4

## FIG. 5

**FIG. 6**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

• US 5454266 A

**In der Beschreibung aufgeführte Nicht-Patentliteratur**

• A 15B ELECTROMECHANICAL SIGMA-DELTA CONVERTER FOR ACCELERATION MEASURE-MENTS. **SMITH T et al.** IEEE INTERNATIONAL SOLID STATE CIRCUITS CONFERENCE. IEEE INC,

• A CMOS SWITCHED-CAPACITOR INTERFACE CIRCUIT FOR AN INTEGRATED ACCELEROME-TER. **KULAH H et al.** PROCEEDINGS OF THE 43RD. IEEE MIDWEST SYMPOSIUM ON CIRCUITS AND SYSTEMS